# EUROPEAN PATENT APPLICATION

(11) **EP 1 530 230 A2**
(43) Date of publication of application: **11.05.2005**
(21) Application number: 04256330.4
(22) Date of filing: 14.10.2004
(51) Int. Cl.: H01J 37/32

(54) **Helical resonator type plasma processing apparatus**

(30) Priority: 04.11.2003 KR 2003077762
(71) Applicant: Samsung Electronics Co., Ltd., Suwon-si, Gyeonggi-do (KR)
(72) Inventor: Kim, Dae-Il 503-504, Sinjeong Maeul, Yongin-si, Gyeonggi-do (KR); Kim, Gook-yoon Ra-1203 Hynix Sawon Apt, Cheongju-si, Chungcheongbuk-do (KR); Ma, Dong-joon 6-1108, Plaza Apt, Anyang-si, Gyeonggi-do (KR); Choi, Sung-Kyu c/o Samsung Adv Instit of Tech, Yongin-Si Gyeonggi-do (KR)
(74) Representative: Greene, Simon Kenneth

(57) **Abstract**

Provided is helical resonator plasma processing apparatus (100). The plasma processing apparatus comprises a process chamber (150) having a substrate holder (160) for supporting a substrate (W), a dielectric tube (110) disposed on the process chamber to communicate with the process chamber, a helix coil (120) wounded around the dielectric tube, and an RF power source (128) to supply RF power to the helix coil. The dielectric tube has a double tube shape and comprises an inner tube (112) and an outer tube (114), and a plasma source gas inlet port (116) to supply plasma source gas into a space between the inner tube and the outer tube is disposed in the outer tube. A control electrode (130) to control plasma potential is disposed in the dielectric tube. This plasma processing apparatus provides a uniform plasma density distribution along a radial direction of a wafer, and easy control of the plasma potential in the process chamber.

## Description

The present invention relates to a plasma processing apparatus, and more particularly, to a helical resonator type plasma processing apparatus using a helix coil.

Presently, plasma sources are widely used for processing fine semiconductor devices or flat display panels in the semiconductor industry. That is, plasma sources are becoming indispensable tools for etching thin films or deposition of predetermined thin material films on a surface of a wafer for manufacturing semiconductor devices or on a substrate for manufacturing a flat panel display such as an LCD. Accordingly, the development of an apparatus for processing plasma sources is becoming a core requirement for the semiconductor industry.

Integration density of semiconductor devices has drastically increased in recent years with the rapid growth of semiconductor technologies. And also to enhance process efficiency, a diameter of a wafer for manufacturing semiconductor devices has to increase. In order to satisfy these industrial trends, it is essential to ensure plasma uniformity for etching or deposition of very thin films. For this purpose, a variety of attempts to obtain plasma sources having high density and higher density uniformity with normal production at low temperature have been actively carried out regarding plasma production mechanisms such as an inductively coupled plasma (ICP) mechanism, an electron cyclotron resonance (ECR) mechanism, a helicon plasma mechanism, and a helical resonator plasma mechanism.

Among the above plasma production mechanisms, it has been reported that the helical type resonator is the most suitable source for igniting and maintaining a high density plasma at low temperature. Especially, the directionality of sputtered particles resulted from the structural characteristic of the helical type resonator provides a higher applicability for etching apparatuses. In spite of such structural advantage, the helical resonator plasma sources are not widely applied to semiconductor processes for etching or deposition because of difficulties in securing plasma density uniformity in radial directions of a wafer in a process chamber.

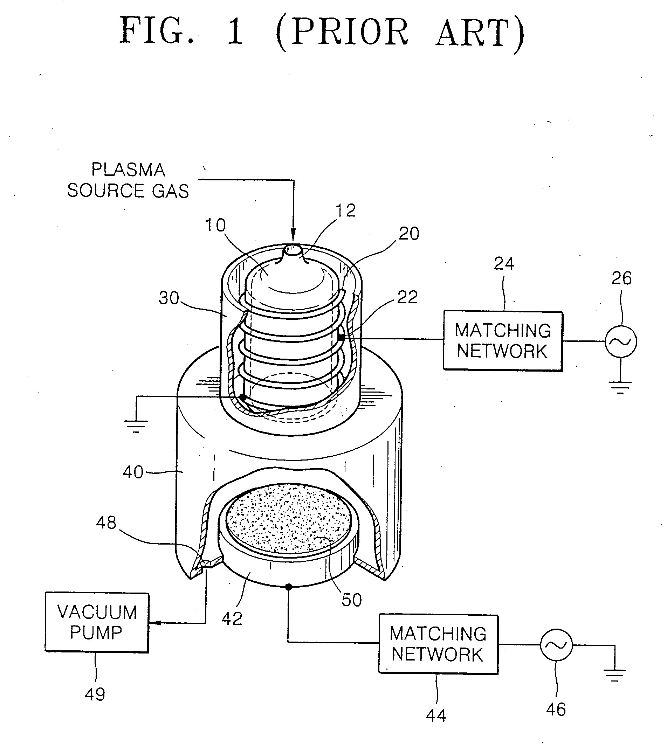

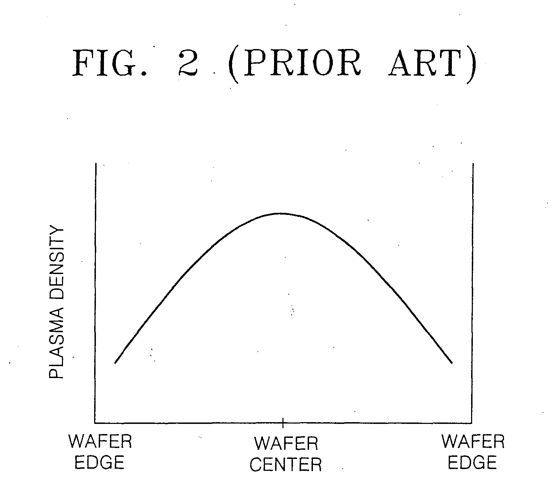

FIG. 1 is a schematic drawing of a partially broken away perspective view of a conventional helical resonator plasma processing apparatus, and FIG. 2 shows density distribution of plasma close to a substrate in a process chamber.

Referring to FIG. 1, a helix coil 20 is wound around a dielectric tube 10 which is usually made of quartz. A gas inlet port 12 for supplying a plasma source gas is formed on an upper part of the dielectric tube 10. A lower end of the helix coil 20 is grounded while an upper end is open. A tap 22 is formed on a predetermined location on the helix coil 20, and an RF power source 26 is connected to the tap 22 via a matching network 24. A metal cylinder 30 is disposed around the helix coil 20. The metal cylinder 30, the helix coil 20, and the dielectric tube 10 are coaxially disposed in a process chamber 40. The process chamber 40 is maintained in a vacuum state. For this purpose, a vacuum suction port 48 connected to a vacuum pump 49 is formed on a bottom wall of the process chamber 40. A wafer holder 42 for supporting a wafer 50 to be processed is disposed on the lower part of the process chamber 40. The wafer holder 42 is connected to an RF power source 46 for supplying a bias power to the wafer holder 42 via a matching network 44.

When the plasma source gas is supplied to the dielectric tube 10 through the gas inlet port 12 and an RF power generated by the RF power source26 is supplied to the helix coil 20 via the matching network 24 and the tap 22, high density plasma is produced in the dielectric tube 10. The produced plasma is diffused into the process chamber 40 toward the wafer 50 to be processed for either etching by a chemical reaction with the wafer 50 or deposition of a predetermined material film on a surface of the wafer 50.

High density plasma is produced in the dielectric tube 10, which has a relatively small diameter, and diffuses into the process chamber 40, which has a relatively bigger diameter. The high density plasma diffused into the process chamber 40 mainly travels vertically toward the wafer 50 and also travels in radial directions to some extent. However, as depicted in FIG. 2, the plasma density of the wafer 50 is higher in the central portion thereof in spite of the radial diffusion due to the directionality of the plasma produced in a helical resonator. This means that plasma density distribution along the radial direction of the wafer 50 is not uniform.

That is, the conventional helical resonator plasma processing apparatus has a difficulty in obtaining a uniform plasma density along the radial direction of the wafer 50. Particularly, this problem becomes severer when the wafer 50 has a large diameter. The non-uniformity of plasma density can create differences in an etching depth and film thickness of material deposited on the wafer 50. These problems can significantly reduce the quality of semiconductor devices as well as the process yield.

Meanwhile, a produced plasma potential is needed for a suitable control according to a process type or process conditions. For example, when a relatively higher bias potential is applied to the wafer 50 from an RF power source 46 connected to a wafer holder 42, a cliffing effect by the plasma may rise on edges of a thin film which has a high aspect ratio because stresses are concentrated on the edges. To avoid the cliffing effect, it is necessary to increase the plasma potential and lower the bias potential. On the contrary, it is necessary to maintain a low plasma potential for etching or deposition of a nano unit thin film for a higher process precision. However, a conventional helical resonator plasma processing apparatus has a drawback in adequately controlling the plasma potential for a particular process and process conditions.

Accordingly, there is a need for a plasma processing apparatus able to ensure high plasma density, maintaining uniform plasma density distribution, and easily controlling the plasma potential.

According to an aspect of the present invention, a helical resonator plasma processing apparatus comprises a process chamber having a substrate holder that supports a substrate to be processed, a dielectric tube disposed on the process chamber to communicate with an inner space of the process chamber, the dielectric tube comprising an inner tube, an outer tube that surrounds the inner tube, and a source gas inlet port disposed on the outer tube to supply a plasma source gas into the inner space between the inner tube and the outer tube of the process chamber, a helix coil wound around outer tube of the dielectric tube, and an RF power source to apply an RF power to the helix coil.

According to another aspect of the present invention, the helical resonator plasma processing apparatus further comprises a control electrode to control a plasma potential generated in the dielectric tube disposed in the dielectric tube and a variable DC power source to apply a predetermined potential to the control electrode.

The control electrode is preferably disposed between an upper part of the inner tube and an upper part of the outer tube.

Preferably, the control electrode is disposed below the source gas inlet port and has a plurality of holes through which the source gas to be passed.

Preferably, a plasma distributor having a plurality of holes is disposed at a lower part of the dielectric tube. In this case, preferably the plasma distributor is formed in a ring shape corresponding to a space between the inner tube and the outer tube.

Preferably, one the helix coil end is grounded and the other end is electrically opened, and the open end is wrapped in a ceramic.

Preferably, a plurality of taps are formed on different locations on the helix coil, and a switch to apply the RF power selectively to the taps can be disposed between the taps and the RF power source. In this case, each tap of the plurality of taps is disposed on every other turn of the helix coil.

Preferably, the helix coil has a square cross-sectional shape.

A metallic cylinder can be disposed around the helix coil. A radiation fan to dissipate heat generated by the helix coil to the outside can be disposed inside of the metallic cylinder, and a plurality of holes to exhaust air to the outside can be formed on the cover of the metallic cylinder.

According to another aspect of the present invention, the helical resonator plasma processing apparatus further comprises a plurality of magnets disposed along the inner circumference of the process chamber, spaced apart at predetermined distance.

A magnet supporting unit having a cylindrical shape to support the plurality of magnets can be disposed close to an inner circumference of the process chamber, and preferably a plurality of slots are formed on the magnet supporting unit so that each magnet is inserted in a slot. Preferably, a cooling line to cool the magnets is disposed on the magnet supporting unit.

Preferably, a protecting unit having a cylindrical shape to protect the magnets from the plasma is disposed on an inner side of the magnet supporting unit.

According to another aspect of the present invention, the helical resonator plasma processing apparatus further comprises a process gas injection unit to inject a process gas for processing a wafer placed in the process chamber. Preferably, the process gas injection unit comprises a gas inlet installed through a wall of the process chamber, an injector having a ring shape disposed in the process chamber, and a plurality of gas distribution holes being formed in the injector to distribute a process gas from the gas inlet into the process chamber.

The RF power source can be electrically connected to the helix coil via a matching network.

The substrate holder is connected to a bias power source, the bias power source is a RF power source, and the RF power source is preferably electrically connected to the substrate holder via a matching network.

According to another aspect of the present invention, a helical resonator plasma processing apparatus comprises a process chamber having a substrate holder that supports a substrate to be processed, a dielectric tube disposed on the process chamber to communicate with an inner space of the process chamber in which a source gas inlet port to supply a plasma source gas is disposed, a helix coil wound around the dielectric tube, an RF power source to apply an RF power to the helix coil, a control electrode to control a plasma potential produced in the dielectric tube disposed in the dielectric tube, and a variable DC power source to apply a predetermined potential to the control electrode.

The use of a plasma processing apparatus according to the present invention provides an improvement in density uniformity of plasma close to a wafer along the radial direction of the wafer, and an easy way to control a plasma potential in a process chamber.

The present invention thus provides a helical resonator plasma processing apparatus configured to improve density uniformity of plasma close to a wafer, and to control easily a plasma potential in a process chamber.

The above and other features and advantages of the present invention will become more apparent by describing in detail preferred embodiments thereof with reference to the attached drawings in which:
FIG. 1 is a partially broken away perspective view of a conventional helical resonator plasma processing apparatus;
FIG. 2 is a graph showing density distribution of plasma close to a wafer in a conventional plasma process chamber;
FIG. 3 is a vertical cross-sectional view of a helical resonator plasma processing apparatus according to a preferred embodiment of the present invention;
FIG. 4 is a partially broken away perspective view of a dielectric tube, the control electrode, a helix coil, and a plasma distributor depicted in FIG. 3;
FIG. 5 is a perspective view of a control electrode different from the one depicted in FIG. 4;
FIG. 6 is a partially exploded perspective view of a metallic cylinder cover and a radiation fan depicted in FIG. 3;
FIG. 7 is a partially exploded perspective view of a mounting configuration of a magnet depicted in FIG. 3;
FIG. 8 is a partially broken perspective view of a process gas injection unit depicted in FIG. 3; and
FIG. 9 is a schematic diagram showing density distribution of plasma close to a wafer in a process chamber of a helical resonator plasma processing apparatus, according to the present invention.

Hereinafter, the present invention will be described more fully with reference to the accompanying drawings in which preferred embodiments of the invention are shown by way of example. Like reference numerals refer to like elements throughout the drawings.

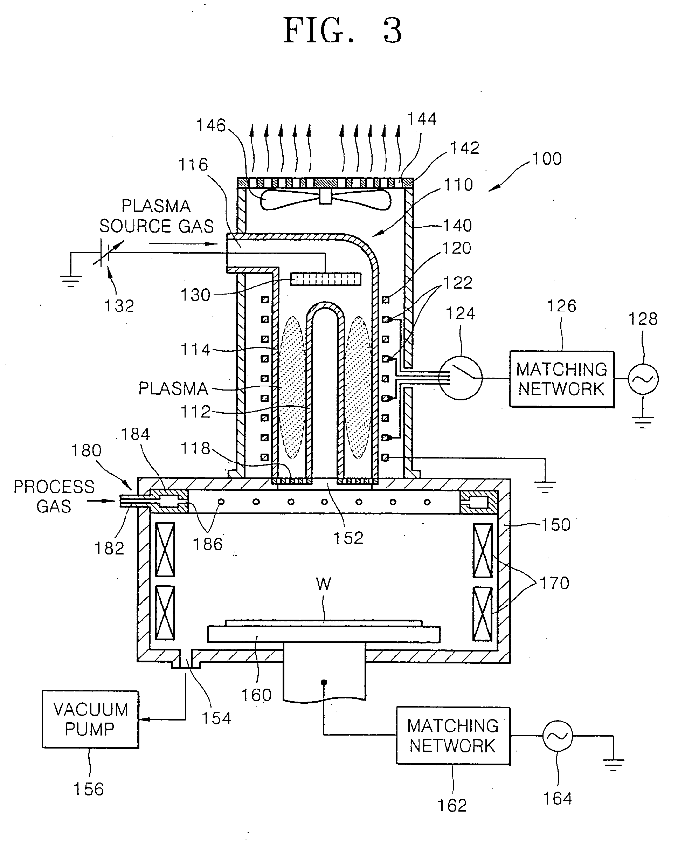

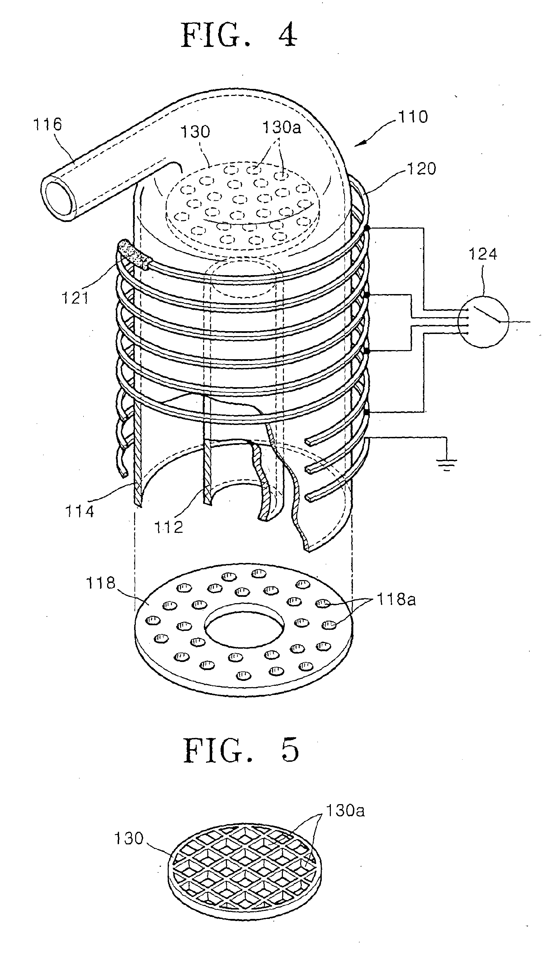

FIG. 3 is a vertical cross-sectional view of a helical resonator plasma processing apparatus according to a preferred embodiment of the present invention. FIG. 4 is a partially broken away perspective view of a dielectric tube, a control electrode, a helix coil, and the plasma distributor depicted in FIG. 3.

Referring to FIGS. 3 and 4, a helical resonator plasma processing apparatus according to the present invention is a sort of a semiconductor manufacturing apparatus for performing a fine processing such as etching a surface of a substrate or depositing a predetermined material layer on a substrate by using plasma produced by a helical resonator 100. The substrate which is loaded in a process chamber 150 can be a silicon wafer W for manufacturing a semiconductor device.

The helical resonator plasma processing apparatus comprises a process chamber 150 having a substrate holder 160 that supports the wafer W and a helical resonator 100 that produces plasma, disposed on the process chamber 150.

The helical resonator 100 includes a dielectric tube 110 disposed on the process chamber 150, a helix coil 120 wound around the dielectric tube 110, and an RF power source 128 for supplying RF power to the helix coil 120

The dielectric tube 110 communicates with the process chamber 150 through a connection hole 152 formed on a ceiling wall of the process chamber 150, and is preferably made of quartz.

The dielectric tube 110 is formed of a double tube shape comprising an inner tube 112 and an outer tube 114 which surrounds the inner tube 112. An upper part of the inner tube 112 is blocked and a lower part is opened. A source gas inlet port 116 for supplying source gas into a space between the inner tube 112 and the outer tube 114 is formed at the upper part of the outer tube 114, and the lower part of the outer tube 114 is opened toward the process chamber 150.

In the dielectric tube 110, a plasma source gas supplied through the source gas inlet tube 116 does not fill an inner space of the inner tube 112 but fills a space between the inner tube 112 and the outer tube 114. Accordingly, plasma produced by the RF power supplied to the helix coil 120 stays in the space between the inner tube 112 and the outer tube 114. Thus, the plasma has a doughnut shape. The doughnut shaped plasma travels into the process chamber 150 toward the wafer W, and has a uniform density distribution close to the wafer W, which will be particularly described later.

It is preferable that a plasma distributor 118 having a plurality of holes 118A is disposed at the lower end of the dielectric tube 110. The plasma distributor 118 is disposed between the dielectric tube 110 and the process chamber 150. The plasma distributor 118 can be formed in a ring shape corresponding to the space between the inner tube 112 and the outer tube 114, and can be inserted into the connection hole 152 formed on the ceiling wall of the process chamber 150.

The plasma distributor 118 is configured to distribute the plasma produced in the dielectric tube 110 into the process chamber 150 more evenly and widely by passing it through the plurality of holes 118A. Thus, a uniform plasma density distribution across a radial direction in the process chamber 150 is achieved.

The helix coil 120 is wound around the dielectric tube 110 with a multiple turns, and an end thereof, i.e., conventionally a lower end, is grounded (grounded end) and the other end, i.e., an upper end, is electrically open (open end). Preferably, the open end is wrapped by a ceramic 121. The purpose of the ceramic is to protect a spark discharge that may occur between the open end of the helix coil 120 and other adjacent components.

An RF power from the RF power source 128 is supplied to the helix coil 120. For a higher coupling efficiency, the RF power can be applied to the helix coil 120 via a matching network 126.

When the RF power is supplied to an arbitrary point of the helix coil 120, a time-varying magnetic field is formed by a current flowing through the helix coil 120, and an electromagnetic field is induced by the time-varying magnetic field. The induced electromagnetic field produces plasma by ionizing the plasma source gas. At this time, one end from the point where the RF power tapped on the helix coil 120, i.e., the grounded end, is inductively coupled, and the other end, i.e., the opened end, is capacitively coupled, thereby generating a resonance. At this condition, an effective energy transfer to the helix coil 120 can be made by the resonance (LC resonance) generated. Therefore, high density plasma can be produced by the helical resonator 100.

A plurality of taps 122 to be connected to the RF power source 128 are formed on the helix coil 120. The plurality of taps 122 are configured on different locations of the helix coil 120. For example, one tap can be disposed on every other turns of helix coils 120. A switch 124 can be disposed between the plurality of taps 122 and the RF power source 128 so that the RF power can be selectively supplied to the plurality of taps 122.

Conventionally, to find an optimum tapping point for obtaining an optimum resonant state, resonances of different points are measured by tapping the RF power to the helix coil from one point to another. However, the RF power tapping point to obtain an optimum resonance of the present invention can be easily detected by manipulating the switch 124 disposed between the taps 122 and the RF power source 128. Thus, high density plasma can be effectively preserved.

The helix coil 120 can have a circular cross-sectional shape ; however, preferably, the helix coil 120 has a square cross-sectional shape as depicted in FIGS. 3 and 4. The square cross-sectional shape helix coil 120 increases the plasma generation efficiency due to its increased surface area. More specifically, the increased surface of the helix coil 120 reduces impedance at the grounded end of the helix coil 120, thereby reducing an inductance by increasing a current. Accordingly, an inductively coupled plasma generation efficiency increases by the inductively supplied RF energy. On the other hand, a capacitance at the other end, i.e., the open end of the helix coil 120 increases due to the increased surface area of the helix coil 120, thereby is increasing capacitively coupled plasma generation efficiency at the open end.

The plasma processing apparatus according to the present invention can further include a control electrode 130 in the dielectric tube 110 and a variable DC power source 132 for applying a predetermined potential to the control electrode 130. The control electrode 130 disposed in the dielectric tube 110 is configured to control plasma potential produced in an inner space of the dielectric tube 110.

The control electrode 130 can be disposed on an upper part of the inner tube 112 and on an upper part of the outer tube 114. When the source gas inlet port 116 is disposed above the control electrode 130, preferably, a plurality of holes 130A for allowing the source gas flow therethrough can be formed in the control electrode 130. When the source gas inlet port 116 is disposed under the control electrode 130, the plurality of holes do not need to be formed.

Meanwhile, another type of the control electrode 130 is shown in FIG. 5. As depicted in the drawing, the control electrode 130 can be configured in a mesh shape having an array of holes 130A thereon.

The control electrode 130 is configured to control easily the plasma potential produced in the dielectric tube 110. More specifically, when etching a thin film having a high aspect ratio, a bias potential applied to the substrate holder 160 has to be reduced while the plasma potential has to be increased. In this case, the plasma potential that conventionally is positively charged can be increased by applying the same charge, i.e., a positive charge, to the control electrode 130 from the variable DC power source 132. Accordingly, a cliffing effect by which an edge of a thin film which has a high aspect ratio is eroded due to the stress concentration on the edge during etching can be avoided by the lowered bias potential applied to the wafer W, and an etching process can be preformed effectively with the increased plasma potential. However, when depositing a thin film having a nano unit thickness such as an atomic layer deposition (ALD) or etching a thin film having a nano unit thickness with a very high precision, the plasma potential has to be maintained low. In this case, the low plasma potential can be attained by applying a counter charge against the plasma potential, i.e., a negative charge, to the control electrode 130.

The control electrode 130 enables the plasma processing apparatus according to the present invention to adequately operate under different conditions and to control a precision process effectively.

Meanwhile, although the control electrode 130 is disposed within the dielectric tube 110 having two tubes, the control electrode can also be disposed in a dielectric tube having a single tube as depicted in FIG. 1. The plasma potential in this case can also be easily controlled by the control electrode 130.

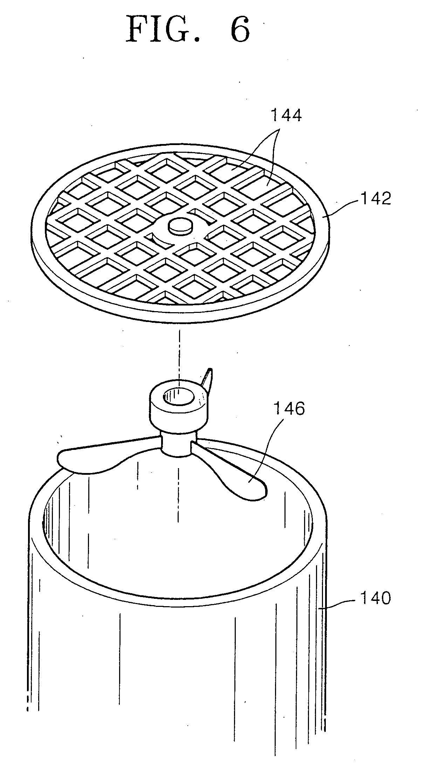

FIG. 6 is a partially exploded perspective view of the metallic cylinder cover and the radiation fan depicted in FIG. 3.

Referring to FIGS. 3 and 6, in the plasma processing apparatus according to the present invention, a metallic cylinder 140, having a tubular shape for protecting the dielectric tube 110 and the helix coil 120 and for blocking an electromagnetic wave, can be disposed around the helix coil 120. The metal cylinder 140 can be formed of aluminum, but it is preferably formed of cupper, which has superior heat and electric conductivity and higher strength.

Preferably, a radiation fan 146 for dissipating heat generated from the helix coil 120 to the outside is disposed in the metallic cylinder 140. The radiation fan 146 can be supported by a cover 142 for the metallic cylinder 140. A plurality of holes 144, through which hot air in the metal cylinder 140 can be discharged into the air, are formed on the cover 142 of the metallic cylinder 140.

The configuration of the radiation fan 146 and the cover 142 that can prevent the helical resonator 100 from overheating enables the apparatus to be operated continuously and steadily.

To process a wafer of large diameter, a plurality of helical resonators 100 having the same configuration as described above can be disposed on a process chamber 150. This is because the diameter of the helical resonator 100 to obtain a uniform plasma density along radial directions of the wafer W cannot be increased much. When a diameter of a helical resonator 100 becomes excessively big, a voltage to be applied to the helix coil 120 also should be increased. In this case, two to four helical resonators 100, for example, in one process chamber 150 according to the size of the wafer W can be disposed, and then a higher plasma density distribution over the large wafer W can be obtained.

Referring to FIG. 3 again, inside of the process chamber is maintained vacuum, and for this purpose, a vacuum suction port 154 connected to the vacuum pump 156 is formed on a bottom wall of the process chamber 150. A substrate holder 160 that supports the wafer W is formed in the process chamber 150.

A bias power source 164 can be connected to the substrate holder 160. The bias power source 164 is configured to apply a bias power to the substrate holder 160 so that the plasma produced by the helical resonator 100 can travel toward the wafer W placed on the substrate holder 160. An RF power source or a pulse DC power source can be used for the bias power source 164. When the bias power source 164 is the RF power source, a matching network 162 for increasing a transfer efficiency of the RF power can be disposed between the bias power source 164 and the substrate holder 160.

The plasma processing apparatus according to the present invention can further comprise a plurality of magnets 170 disposed in the process chamber 150 for forming a magnetic field in the process chamber 150. The magnets 170 can be permanent magnets.

The magnets 170 are disposed at equally spaced distance along the inner circumference of the process chamber 150.

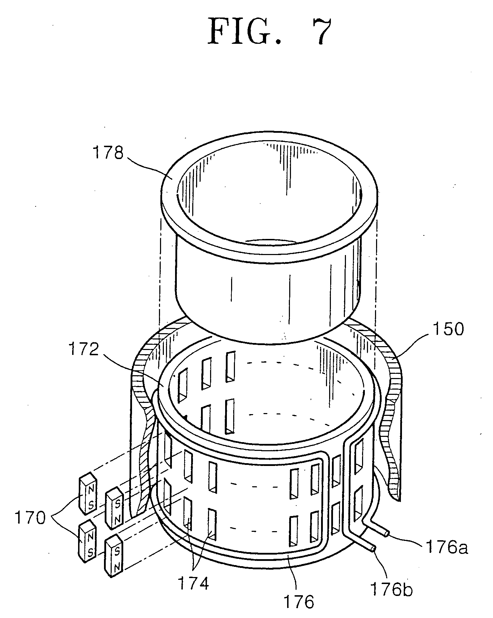

FIG. 7 is a partially exploded perspective view of a mounting configuration of the magnet depicted in FIG. 3.

Referring to FIG. 7, a magnet supporting unit 172, having a cylindrical shape for supporting the plurality of magnets 170, is disposed close to the inner circumference of the process chamber 150. A plurality of slots 174 are formed on the magnet supporting unit 172 and one magnet 170 is supported by being inserted in each slot 174. The plurality of slots 174 can be arranged in two rows as depicted in FIG. 7, or can be arranged in one row or in more than three rows.

A magnetic characteristic of the magnets 170 generally decreases as a temperature increases. Therefore, the temperature of the process chamber 150 has to be maintained as low as possible. For this purpose, preferably, a cooling line 176 for cooling the magnets 170 is disposed on the magnet supporting unit 172. The cooling line which includes a coolant inlet 176A and a coolant outlet 176B can be disposed along edges of the magnet supporting unit 172.

Since the magnets 170 can be damaged or coated with a material film by plasma in the process chamber 150, the magnetic characteristic of the magnets 170 can be degraded. In order to cope with this problem, a protecting unit 178 having a cylindrical shape for protecting the magnets 170 from plasma can be disposed inside of the magnet supporting unit 172.

Due to the directionality of plasma diffusion, plasma that diffuses into the process chamber 150 from the dielectric tube 110 has a lower density distribution at outer regions than in the central region in the process chamber 150. However, the plasma density in the outer regions of the process chamber 150 can be compensated by the formation of a magnetic field with the aid of the magnets 170 disposed along the inner circumference of the process chamber 150. That is, since a plasma density at the edges of the wafer W becomes higher, a uniform plasma density along the radial direction of the wafer W is attained.

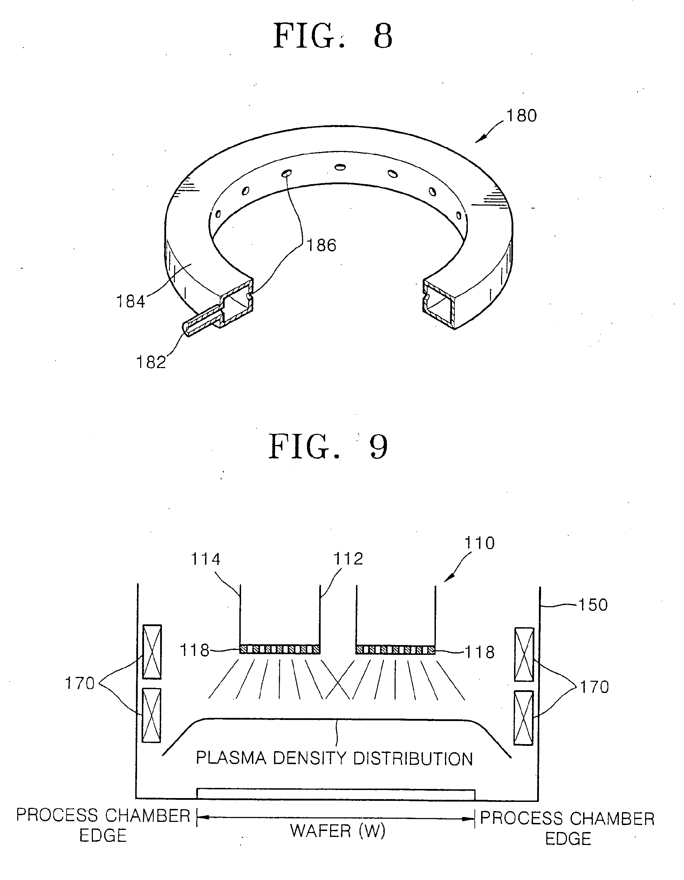

FIG. 8 is a partially broken perspective view of the process gas injection unit depicted in FIG. 3.

Referring to FIGS. 3 and 8, the plasma processing apparatus according to the present invention can further comprise a process gas injection unit 180. The process gas injection unit 180 is configured to inject a process gas such as a gas for chemical vapor deposition or a gas for dry ashing a wafer W in the process chamber 150.

The process gas injection unit 180 includes a gas inlet 182 and a ring shaped injector 184 having a plurality of gas distribution holes 186 for distributing the process gas into the process chamber 150. The gas inlet 182 is mounted through a wall of the process chamber 150, the injector 184 is disposed tightly contacting the inner wall of the process chamber 150, and the plurality of gas distribution holes 186 are disposed on an inner circumference of the injector 184, the distribution holes 186 being spaced apart at substantially equal distance.

The configuration of process gas injection unit 180 enables the injection of various process gases to be distributed uniformly in the process chamber 150. By using the gas injection unit 180, plasma processing apparatus according to the present invention can be used for performing various processes such as a dry etching process, a chemical vapor deposition process, and a dry ashing process.

FIG. 9 is schematic diagram showing density distribution of plasma close to a wafer in a process chamber of a helical resonator plasma processing apparatus according to the present invention.

Referring to FIG. 9, plasma produced in a dielectric tube 110 having a double tube shape flows into the process chamber 150 toward the wafer W. The plasma has a doughnut shape because the plasma is not produced in the inner tube 112 but produced in a space between the inner tube 112 and the outer tube 114 of the dielectric tube 110. This shape of plasma can increase the plasma density at the edges of the wafer W more than in the conventional art. The plasma density at the central part of the wafer W can also be increased at the same level with other areas of the wafer W because the two doughnut shape plasma diffused in radial directions can overlap the central region of the wafer W. Density of plasma close to walls of the process chamber 150 can also be compensated by the magnets 170 disposed in the process chamber 150. Accordingly, the density of plasma close to the wafer W can be uniformly distributed along the radial direction of the wafer W. Moreover, the plasma entering into the process chamber 150 can be further evenly distributed with the aid of the distributor 118 having a plurality of holes 118A disposed on the lower part of the dielectric tube 110. Therefore, the uniformity of the plasma density distribution can be improved.

For example, a plasma density distribution toward a radial direction of a wafer was measured in a plasma processing apparatus according to the present invention having a process chamber which is designed to accommodate a wafer having a diameter of 4 (four) inches. Measurement results showed that an average plasma density was 2x10¹¹cm⁻³, and the density deviation of the plasma, i.e., a difference between the maximum density and the minimum density divided by the maximum density, was approximately 4 %. Considering that the measured plasma density deviation in conventional plasma processing apparatuses lies approximately between 10 and 20%, it can be said that the plasma density deviation measured in the plasma processing apparatus according to the present invention is notably improved.

According to the foregoing discussion, a helical resonator plasma processing apparatus according to the present invention has the following advantages.

First, a density distribution of plasma produced in a dielectric tube and diffusing toward a wafer placed in a process chamber, has higher uniformity along a radial direction of the wafer since the dielectric tube is formed in a double tube shape. When a distributor having a plurality of holes is disposed at the lower part of the dielectric tube, the uniformly distributed plasma can diffuse into the process chamber. Accordingly, even a wafer having a large diameter or a large substrate for manufacturing a flat display panel can be uniformly processed.

Second, a plasma potential formed in a dielectric tube can be easily controlled by a control electrode disposed in the dielectric tube. Therefore, irrespective of a process type and conditions, with precision and effective processing are possible.

Third, an optimum resonance state can be obtained by providing a plurality of taps for selectively applying an RF power to on the helix coil, thereby effectively securing high density plasma.

Fourth, a surface of the helix coil can be increased by adopting a square cross-sectional shape coil, thereby increasing an efficiency of plasma generation.

Fifth, a uniform plasma density distribution along radial directions of the wafer can be achieved by disposing a plurality of magnets along an inner circumference of a process chamber so that the magnets compensate density of plasma on edges of the wafer.

Sixth, by using a gas injection unit the plasma processing apparatus according to the present invention can be used for performing various processes such as a dry etching process, a chemical vapor deposition process, and a dry ashing process.

While this invention has been particularly shown and described with reference to a preferred embodiment thereof, it will be understood by those skilled in the art that various changes in form and details may be made therein without departing from the scope of the invention as defined by the appended claims.

## Claims

1. A helical resonator type plasma processing apparatus, comprising:
a process chamber having a substrate holder for supporting a substrate to be processed;
a dielectric tube having a double tube shape disposed on the process chamber to communicate with an inner space of the process chamber, the dielectric tube comprising:
an inner tube;
an outer tube that surrounds the inner tube; and
a source gas inlet port disposed on the outer tube for supplying a plasma source gas into an inner space between the inner tube and the outer tube,
a helix coil wound around outer tube of the dielectric tube; and
an RF power source for applying an RF power to the helix coil.

2. The apparatus of claim 1, wherein the dielectric tube comprises a plasma distributor having a plurality of holes at a lower part of the dielectric tube.

3. The apparatus of claim 2, wherein the plasma distributor is formed in a ring shape corresponding to a space between the inner tube and the outer tube.

4. The apparatus of any preceding claim, further comprising:
a control electrode disposed in the dielectric tube for controlling a plasma potential generated in the dielectric tube; and
a variable DC power source for applying a predetermined potential to the control electrode.

5. The apparatus of claim 4, wherein the control electrode is disposed between an upper part of the inner tube and an upper part of the outer tube.

6. A helical resonator plasma processing apparatus, comprising:
a process chamber having a substrate holder for supporting a substrate to be processed;
a dielectric tube disposed on the process chamber to communicate with an inner space of the process chamber, in which a source gas inlet port for supplying a plasma source gas is disposed;
a helix coil wound around the dielectric tube;
an RF power source for applying an RF power to the helix coil;
a control electrode disposed in the dielectric tube for controlling a plasma potential produced in the dielectric tube; and
a variable DC power source for applying a predetermined potential to the control electrode.

7. The apparatus of any one of claims 4 to 6, wherein
the control electrode is disposed below the source gas inlet port, and
the control electrode has a plurality of holes through which the plasma source gas is to be passed.

8. The apparatus of any one of claims 4 to 7, wherein the control electrode has a mesh shape.

9. The apparatus of any preceding claim, wherein the dielectric tube is made of quartz.

10. The apparatus of any preceding claim, wherein one end of the helix coil is grounded and the other end is electrically open, and the open end is wrapped in ceramic.

11. The apparatus of claim 1, wherein the helix coil includes:
a plurality of taps formed on different locations on the helix coil; and
a switch disposed between the taps and the RF power source for applying the RF power selectively to the taps.

12. The apparatus of claim 11, wherein a tap is disposed on every other turn of the helix coil.

13. The apparatus of any preceding claim, wherein the helix coil has a square cross-sectional shape.

14. The apparatus of any preceding claim, wherein a metallic cylinder is disposed around the helix coil.

15. The apparatus of claim 14, wherein the metallic cylinder is formed of copper.

16. The apparatus of claim 14 or 15, wherein an inner side of the metal cylinder includes:
a radiation fan disposed inside the metallic cylinder for dissipating heat generated by the helix coil to the outside; and
a plurality of holes formed on a cover of the metallic cylinder for exhausting air to the outside.

17. The apparatus of claim 16, wherein the radiation fan is supported by the cover of the metallic cylinder.

18. The apparatus of any preceding claim, further comprising a plurality of magnets disposed along the inner circumference of the process chamber, spaced apart at predetermined distances.

19. The apparatus of claim 18, wherein the magnets are permanent magnets.

20. The apparatus of claim 18 or 19, wherein the process chamber comprises a magnet supporting unit disposed close to an inner circumference of the process chamber and having a cylindrical shape for supporting the plurality of magnets.

21. The apparatus of claim 20, wherein the magnet supporting unit has a plurality of slots so that a permanent magnet is inserted in each slot.

22. The apparatus of claim 21, wherein the plurality of slots are arrayed in two rows.

23. The apparatus of any one of claims 20 to 22, wherein the magnet supporting unit has a cooling line for cooling the permanent magnets.

24. The apparatus of claim 23, wherein the cooling line is disposed on an edge of the magnet supporting unit.

25. The apparatus of any one of claims 20 to 24, wherein the magnet supporting unit comprises a protecting unit having a cylindrical shape for protecting the magnets from the plasma, the protecting unit being disposed on an inner side of the magnet supporting unit.

26. The apparatus of any preceding claim, further comprising a process gas injection unit for injecting a process gas for processing a wafer placed in the process chamber.

27. The apparatus of claim 26, wherein the process gas injection unit comprises:
a gas inlet installed through a wall of the process chamber;
an injector having a ring shape and disposed in the process chamber; and
a plurality of gas distribution holes formed in the injector for distributing a process gas passing through the gas inlet into the process chamber.

28. The apparatus of any preceding claim, wherein the RF power source is electrically connected to the helix coil via a matching network.

29. The apparatus of any preceding claim, wherein the substrate holder is connected to a bias power source.

30. The apparatus of claim 29, wherein the bias power source is an RF power source and the RF power source is electrically connected to the substrate holder via a matching network.
